(19) **Europäisches Patentamt**

**European Patent Office**

**Office européen des brevets**

(11) **EP 0 924 853 B1**

(12) **FASCICULE DE BREVET EUROPEEN**

(45) Date de publication et mention
de la délivrance du brevet:
**17.03.2004 Bulletin 2004/12**

(51) Int Cl.⁷: **H03D 7/14**

(21) Numéro de dépôt: **98204161.8**

(22) Date de dépôt: **08.12.1998**

(54) **Circuit mélangeur à diodes**

Diodenmischerschaltung

Diode mixer circuit

(84) Etats contractants désignés:
**DE ES FR GB IT**

(30) Priorité: **15.12.1997 FR 9715881**

(43) Date de publication de la demande:
**23.06.1999 Bulletin 1999/25**

(73) Titulaire: **Koninklijke Philips Electronics N.V.**
**5621 BA Eindhoven (NL)**

(72) Inventeurs:
• **Stikvoort, Eduard Ferdinand, Sté Civile S.P.I.D.**
**75008 Paris (FR)**
• **Baltus, Petrus Gerdardus Maria,**
**Sté Civile S.P.I.D**
**75008 Paris (FR)**
• **Tombeur, Antoon Marie Henrie,**
**Société Civile SPID**
**75008 Paris (FR)**

(74) Mandataire: **Charpail, François et al**
**Société Civile S.P.I.D.**
**156, Boulevard Haussmann**
**75008 Paris (FR)**

(56) Documents cités:
**US-A- 3 706 042     US-A- 5 265 269**

• **PATENT ABSTRACTS OF JAPAN vol. 007, no.
072 (E-166), 25 mars 1983 & JP 58 003404 A
(TOKYO SHIBAURA DENKI KK), 10 janvier 1983**

**Description**

DOMAINE TECHNIQUE

L'invention définie dans la revendication concerne un circuit mélangeur à diodes pour mélanger un premier et un deuxième signal d'entrée. L'invention concerne également un récepteur dans lequel un signal de réception et un signal de battement sont mélangés afin d'obtenir un signal de fréquence intermédiaire.

ETAT DE LA TECHNIQUE ANTERIEURE

Le livre "High Frequency Circuit Design" par James K. Hardy, Preston Publishing Company, 1979, pages 317-318, décrit des circuits mélangeurs. La figure 10-6(f) de ce livre montre un circuit mélangeur ayant une structure de "double balance" (en anglais: double-balanced mixer). Le circuit contient quatre diodes qui sont connectées de telle manière qu'ils forment un anneau. L'anneau de diodes reçoit un signal de haute fréquence (RF) et un signal oscillateur (OSC) par intermédiaire d'un transformateur. Un signal de fréquence intermédiaire (IF) est obtenu par intermédiaire d'un autre transformateur. Grâce à la structure de double balance, il y a relativement peu de résidu du signal oscillateur dans le signal de fréquence intermédiaire.

EXPOSE DE L'INVENTION

Un but de l'invention est de fournir un circuit mélangeur à diodes qui permet une variété d'applications plus importante.

L'invention prend les aspects suivants en considération. Dans l'art antérieur, chaque transformateur doit être capable de traiter des signaux d'une façon sensiblement symétrique et sans trop de pertes afin que le circuit mélangeur ait une performance satisfaisante. La fabrication d'un tel transformateur nécessite des matériaux spéciaux et une méthode relativement compliquée. En plus, un tel transformateur doit avoir certaines dimensions minimales; on ne peut pas miniaturiser le transformateur à volonté sans dégrader sa performance. Donc, le transformateur est un élément relativement coûteux et relativement volumineux. Par conséquence, le circuit mélangeur selon l'art antérieur ne convient pas dans des applications à faible coût comme, par exemple, dans le domaine de l'électronique grand public. Il ne convient pas non plus dans des applications miniatures comme, par exemple, des récepteurs portable.

Selon l'invention, un circuit mélangeur à diodes comprend un circuit d'attaque pour fournir un premier, deuxième, troisième et quatrième signal d'attaque. Chaque signal d'attaque est une combinaison d'un premier et d'un deuxième signal d'entrée. Le premier et le deuxième signal d'entrée (LO,RF) ont les signes suivants dans le premier, deuxième, troisième et quatrième signal d'attaque: +/+, +/-, -/+ et -/-, respectivement. En outre, il y a un groupe de diodes comprenant une première, deuxième, troisième et quatrième diode. Ces diodes sont couplées pour transférer le premier, deuxième, troisième et quatrième signal d'attaque, respectivement, vers une sortie. La première et la quatrième diode ont la même polarité par rapport à la sortie. La deuxième et la troisième diode ont également la même polarité par rapport à la sortie, mais opposée à celle de la première et quatrième diode.

Le circuit d'attaque peut être réalisé sans utiliser un transformateur. Par exemple, le circuit d'attaque peut être réalisé en utilisant exclusivement des transistors, résistances et capacités. Le groupe de diodes peut être relié à la sortie sans intermédiaire tel qu'un transformateur. Donc, un circuit mélangeur selon l'invention ne nécessite pas un transformateur contrairement au circuit mélangeur selon l'art antérieur. Par conséquence, un circuit mélangeur à diodes selon l'invention peut être utilisé dans des applications pour lesquelles le circuit mélangeur selon l'art antérieur ne convient pas à cause du fait qu'il contient des transformateurs. Donc, l'invention permet une variation d'applications plus importante.

En particulier, un mélangeur à diodes selon l'invention peut être réalisé sous forme d'un circuit intégré, tandis que ceci n'est pratiquement pas possible pour le circuit selon l'art antérieur. Certaines applications nécessitent qu'un circuit mélangeur soit réalisé sous forme d'un circuit intégré, par exemple pour des raisons de coût et/ou dimensions. Donc, l'invention permet d'utiliser un circuit mélangeur à diodes dans une telle application.

Un autre avantage de l'invention et le suivant. Un circuit mélangeur à diodes est capable d'atteindre une performance relativement favorable, notamment en termes de bruit et distorsion. Comme expliqué ci-dessus, l'invention permet d'utiliser un circuit mélangeur à diodes dans une application pour laquelle le circuit mélangeur selon l'art antérieur ne convient pas. Donc, l'invention permet à une telle application de bénéficier des performances favorables d'un circuit mélangeur qui y est inclus.

L'invention peut avantageusement être appliquée dans un récepteur. En général, un signal d'entrée d'un récepteur est converti en fréquence par mélange avec un signal provenant d'un oscillateur. L'invention permet de réaliser cette conversion en fréquence avec un circuit mélangeur à diodes, même dans le cas ou le récepteur doit être relativement bon marché et/ou relativement petit. Il était déjà mentionné qu'un circuit mélangeur à diodes est capable d'atteindre un faible niveau de bruit et un faible niveau de distorsion. Donc, l'invention permet d'effectuer la conversion en fréquence sans trop affecter le signal d'entrée. En général, le traitement du signal d'entrée au niveau de la conversion de fréquence influence la performance du récepteur dans une large mesure. Par conséquent, l'invention peut sensiblement contribuer à un niveau de performance satisfaisante du récepteur.

L'invention et des caractéristiques additionnelles qui peuvent être utilisées avec avantage pour mettre en oeuvre l'invention, seront décrites ci-dessous plus en grand détail par référence à des figures.

BREVE DESCRIPTION DES FIGURES

La Fig. 1 illustre des caractéristiques de base de l'invention comme revendiquée dans la première revendication.

La Fig. 2 et 3 illustrent des caractéristiques additionnelles comme revendiquées dans la deuxième et troisième revendication, respectivement.

La Fig. 4 illustre un exemple d'un circuit mélangeur selon l'invention.

MODES DE REALISATION DE L'INVENTION

Les remarques suivantes concernent les signes de référence. Des entités similaires sont désignées par une référence par lettres identique dans toutes les figures. Plusieurs entités similaires peuvent apparaître dans une seule figure. Dans ce cas, un chiffre est ajouté à la référence par lettres afin de distinguer entre des entités similaires. Le chiffre peut être omis pour des raisons de convenance. Ceci s'applique pour la description ainsi que pour les revendications.

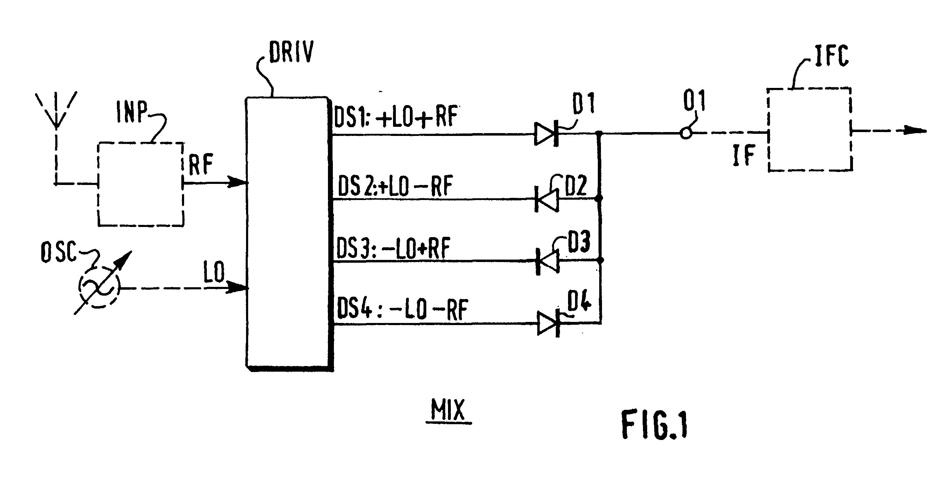

La Fig. 1 illustre des caractéristiques de base de l'invention représentées en traits pleins. Un circuit mélangeur à diodes MIX reçoit un premier et un deuxième signal d'entrée LO,RF qui sont à mélanger. Le circuit mélangeur à diodes MIX comprend un circuit d'attaque DRIV et un groupe de diodes D1-D4.

Le circuit d'attaque DRIV fournit un premier, deuxième, troisième et quatrième signal d'attaque DS1,DS2,DS3,DS4. Chaque signal d'attaque est une combinaison du premier et du deuxième signal d'entrée LO,RF avec les signes suivants :

$$DS1 : +LO+RF \qquad DS2 : +LO-RF \qquad DS3 : -LO+RF \qquad DS4 : -LO-RF$$

Le groupe de diodes D1-D4 contient une première, deuxième, troisième et quatrième diode D1,D2,D3,D4. Ces diodes sont couplées pour transférer le premier, deuxième, troisième et quatrième signal d'attaque DS1,DS2,DS3,DS4, respectivement, vers une sortie O1. La première et la quatrième diode D1,D4 ont la même polarité par rapport à la sortie. La deuxième et la troisième diode D2,D3 ont également la même polarité par rapport à la sortie, mais opposée à celle de la première et quatrième diode D1,D4.

Le circuit mélangeur à diodes MIX fonctionne comme suit. La polarité du signal d'entrée LO détermine lesquelles des diodes D1,D2,D3,D4 sont conductrices et lesquelles sont non-conductrices. Si la polarité du signal d'entrée LO est positive, la première et la troisième diode D1,D3 sont conductrices tandis que la seconde et la quatrième diode D2,D4 sont non-conductrices. Dans ce cas le signal d'entrée RF avec le signe + apparaîtra à la sortie O1. Par contre, si la polarité du signal d'entrée LO est négative, la seconde et la quatrième diode D2,D4 sont conductrices tandis que la première et la troisième diode D1,D3 sont non-conductrices. Dans ce cas, le signal d'entrée RF avec le signe - apparaîtra à la sortie O1. Donc, à la sortie 01 apparaîtra le signal d'entrée RF dont le signe est alterné au rythme du signal d'entrée LO. Ceci correspond à une multiplication du signal d'entrée RF par le signal d'entrée LO. Donc, à la sortie 01 apparaîtra un signal qui est un mélange des deux signaux d'entrée.

Il faut noter qu'en principe aucun des deux signaux d'entrée n'apparaît à la sortie 01 du circuit mélangeur à diodes MIX. Premièrement, il n'existe pas une voie par laquelle le signal d'entrée RF peut continuellement couler vers la sortie 01; il y a toujours un changement de signe alterné. Deuxièmement, l'une et l'autre des deux diodes qui sont conductrices reçoivent le signal d'entrée LO avec des signes opposés, ces deux diodes étant la première et la troisième diode D1,D3 ou la deuxième et la quatrième diode D2,D4. Donc, le signal d'entrée LO s'éteint au point entre les deux diodes conductrices. La sortie 01 est reliée à ce point. Par conséquent, en principe il n'y a pas de résidu du signal entrée LO à la sortie O1.

La Fig. 1 illustre d'autres aspects de l'invention au moyen de lignes en tirets. Le circuit mélangeur à diodes MIX fait partie d'un récepteur REC qui contient en outre un circuit d'entrée INP, un oscillateur OSC, et un circuit de fréquence intermédiaire IFC. Le circuit d'entrée INP traite un signal de réception. L'oscillateur OSC fournit un signal de battement. Le circuit mélangeur MIX mélange le signal de réception traité par le circuit d'entrée INP et le signal de battement fourni par l'oscillateur OSC, afin d'obtenir un signal de fréquence intermédiaire IF. Ensuite, le circuit de fréquence intermédiaire IFC traite le signal de fréquence intermédiaire IF.

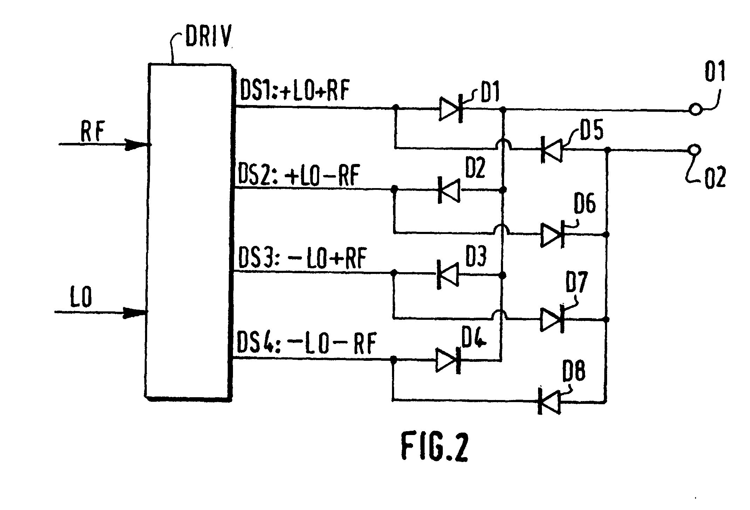

La Fig. 2 illustre des caractéristiques additionnelles pour appliquer l'invention d'une façon avantageuse. Le circuit mélangeur MIX comprend un groupe de diodes additionnel D5-D8. Le groupe de diodes additionnel contient une cinquième, sixième, septième et huitième diode (D5,D6,D7,D8). Ces diodes sont couplées pour transférer le premier, deuxième, troisième et quatrième signal d'attaque (DS1,DS2,DS3,DS4), respectivement, vers une sortie additionnelle (02). Les cinquième, sixième, septième et huitième diodes (D5,D6,D7,D8) sont couplées à l'envers par rapport à la première, deuxième, troisième et quatrième diode (D1,D2,D3,D4), respectivement.

Les aspects suivants ont été pris en considération par rapport à ces caractéristiques additionnelles. Pour qu'il ne reste aucun résidu d'un signal d'entrée RF et LO à la sortie 01, la condition suivante doit être remplie. Dans tous les signaux d'attaque DS1,DS2,DS3,DS4 la partie du signal d'entrée RF ou LO doit être parfaitement égale en terme d'amplitude. En pratique, il est quasiment impossible de remplir cette condition, entre autre a cause des tolérances des composants constituant le circuit d'attaque DRIV.

Si les caractéristiques illustrées dans Fig. 2 sont appliquées, on obtient un signal de sortie différentiel entre la sortie 01 et la sortie O2. Si, à cause des imperfections dans les signaux d'attaque DS1,DS2,DS3,DS4 comme décrit ci-dessus, un résidu d'un signal d'entrée apparaît à la sortie O1, un résidu sensiblement pareil apparaîtra à la sortie O2. Par conséquence, il y aura moins de résidu dans le signal de sortie différentiel. Donc, les caractéristiques illustrées dans la Fig. 2 permettent un niveau de résidu relativement faible.

Un autre avantage des caractéristiques illustrées dans la Fig. 2 est le suivant. Les diodes D1-D8 forment des impédances de charge pour le circuit d'attaque DRIV. Si la polarité du signal d'entrée LO est positive, les diodes D1 et D3 sont conductrices et déterminent l'impédance de charge entre les sorties du circuit d'attaque DRIV qui fournissent les signaux d'attaque DS1 et DS3. Si la polarité du signal d'entrée LO est négative, diodes D5 et D7 sont conductrices et déterminent l'impédance de charge entre les mêmes sorties du circuit d'attaque. Donc, l'impédance de charge entre les sorties du circuit d'attaque DRIV qui fournissent les signaux d'attaque DS1 et DS3, est continuellement formée par deux diodes conductrices. Ceci s'applique également à l'impédance de charge entre les sorties qui fournissent les signaux d'attaque DS2 et DS4. Donc, si les caractéristiques illustrées en Fig. 2 sont appliquées, le circuit d'attaque DRIV est relié à des impédances de charge relativement stables. Si, par contre, le circuit d'attaque DRIV était relié à des impédances de charge qui varient considérablement en fonction de l'amplitude du signal d'attaque, ceci pourrait nuire à la performance du circuit mélangeur. Par conséquence, les caractéristiques illustrées dans Fig. 2 contribuent à une performance satisfaisante.

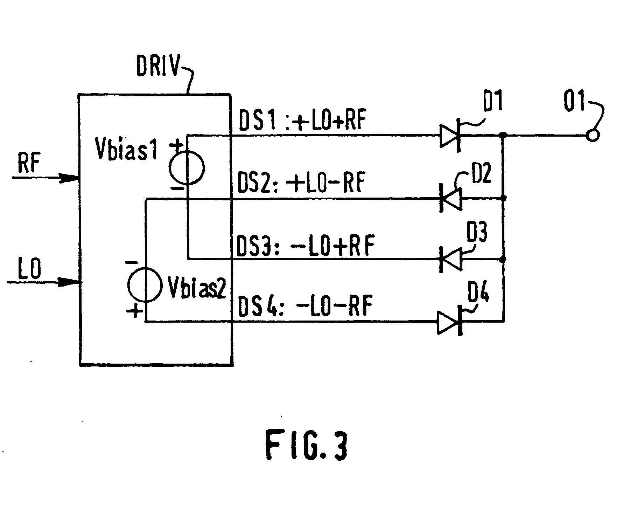

La Fig. 3 illustre des caractéristiques additionnelles pour appliquer l'invention d'une façon avantageuse. Le circuit d'attaque DRIV est à même de fournir des tensions de décalage Vbias1,Vbias2 entre la première et troisième diode D1,D3 et entre la deuxième et la quatrième diode D2,D4, respectivement.

Les aspects suivants ont été pris en considération par rapport à ces caractéristiques additionnelles. Comme mentionné ci-dessus, les diodes du circuit mélangeur sont rendues alternativement conductrices et non-conductrices par le signal d'entrée LO. Ca veut dire qu'il y a successivement une certaine période pendant laquelle une diode est conductrice et, ensuite, une certaine période pendant laquelle la diode est non-conductrice. Si ces deux périodes sont différentes, un résidu du signal d'entrée RF apparaîtra à la sortie O1. En outre, l'efficacité de circuit mélangeur dimunue en proportion d'un écart entre les deux périodes. Donc, il est souhaitable que les périodes dans lesquelles les diodes sont conductrices et non-conductrices, respectivement, soient sensiblement égales.

Si les caractéristiques illustrées en Fig. 3 sont appliquées, les diodes D1,D3 reçoivent une superposition du signal d'entrée LO et de tension de décalage Vbias1. Les diodes D1,D3 seront conductrices si le niveau de cette superposition est au-dessus d'un certain seuil, qui est propre aux diodes D1,D3, et ils seront non-conductrices si le niveau est au-dessous de ce seuil. La tension de décalage Vbias1 détermine à quel niveau du signal d'entrée LO le seuil est atteint et, donc, une transition de conductivité a lieu. A cause du fait qu'il y a un rapport fixe entre le niveau du signal d'entrée LO et le temps, les périodes de conductivité et de non-conductivité des diodes D1,D3 varient en fonction de tension de décalage Vbias1. De la même façon, les périodes de conductivité et de non-conductivité des diodes D2,D4 varient en fonction de tension de décalage Vbias2. Par conséquence, les tensions de décalage Vbias1,Vbias2 permettent d'égaliser les périodes pendant lesquelles les diodes D1,D2,D3,D4 sont conductrices et non-conductrices. Donc, les caractéristiques illustrées en Fig. 3 contribuent à une performance satisfaisante du circuit mélangeur notamment en termes de faible résidu et de haute efficacité.

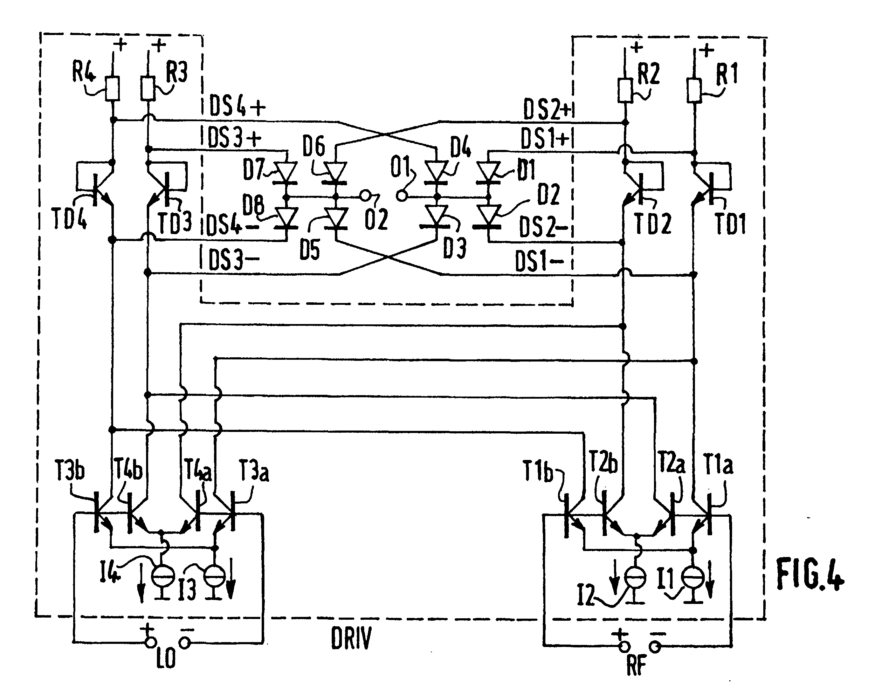

La Fig. 4 illustre un exemple d'un circuit mélangeur à diodes selon l'invention. Cet exemple contient les caractéristiques illustrées en Fig. 1 à 3 qui ont été décrites ci-dessus par rapport à ces Figures. Dans cet exemple, les signaux d'entrée RF,LO sont sous forme différentielle. Chacun des signaux d'attaque DS1-DS4 existe en deux versions qui sont indiquées par l'ajout des signes + et -, respectivement. Les deux versions se distinguent par leur niveaux de tension continue. La tension continue de la version + est supérieur à celle de la version -.

Le circuit d'attaque DRIV comprend quatre paires différentielles de transistors T1a/T1b, T2a/T2b, T3a/T3b et T4a/T4b ayant une source de courant I1,I2,I3 et I4, respectivement. En outre, le circuit d'attaque DRIV comprend quatre transistors TD1,TD2,TD3 et TD4 qui sont en configuration diode, et quatre résistances R1,R2,R3 et R4. Les transistors TD et les résistances R forment des impédances de charge pour les paires différentielles de transistors.

Le circuit d'attaque DRIV fonctionne comme suit. Les paires différentielles T1a/T1b et T2a/T2b reçoivent le signal d'entrée RF et le débitent sous forme de courant via les collecteurs. Les paires différentielles T3a/T3b et T4a/T4b font de même pour le signal d'entrée LO. Chaque transistor ayant un signe de référence finissant par "a" change le signe du signal d'entrée concerné de - en +, tandis que chaque transistor ayant une signe de référence finissant par "b" change le signe du signal d'entrée concerné de + en -.

Les signaux d'entrée RF et LO sous forme de courant sont facilement combinés. Ceci ce fait par des connexions entre les collecteurs des paires différentielles T1a/T1b et T2a/T2b, d'une part, et les collecteurs des paires différentielles T3a/T3b et T4a/T4b, d'autre part. Les connexions sont telles qu'elles produisent quatre combinaisons dans lesquelles les signaux d'entrée LO et RF ont des signes +/+, +/-, -/+ et -/-, respectivement. Ces quatre combinaisons constituent les signaux d'attaque DS1,DS2,DS3 et DS4, respectivement.

Chaque combinaison de signaux d'entrée LO et RF sous forme de courant est appliquée directement à une des diodes D1-D8, d'une part, et via un transistor TD monté en diode, d'autre part. Les combinaisons qui sont appliquées directement constituent les versions "-" des signaux d'attaque DS et les combinaisons qui sont appliquées via les transistors TD constituent les versions "+". Ainsi on obtient des tensions de décalage entre les diodes D1 et D3, les diodes D2 et D4, les diodes D5 et D7 et les diodes D6 et D8. Les tensions de décalage sont déterminés par les jonctions base-émetteur des transistors TD, les valeurs respectives de résistances R et les courants continus débités par les sources I. Si ces derniers courants sont égaux et si tous les résistances R ont la même valeur, les tensions de décalage égalent la tension au travers des jonctions base-émetteur qui est typiquement compris entre 0,6 et 0,8 volt.

Il est préférable que si le circuit mélangeur à diodes est réalisé sous forme d'un circuit intégré, le substrat du circuit intégré soit électriquement isolant. Cette préférence est liée aux aspects suivants qui sont pris en considération.

En pratique, une diode ne peut pas être rendue conductrice instantanément après qu'elle a été non-conductrice et vice versa. Cela veut dire qu'il y a toujours un certain délai de transition pendant lequel la diode est semi-conductrice. Quand la diode est semi-conductrice elle produit relativement beaucoup de bruit. Ceci peut nuire à la performance du circuit mélangeur en terme de bruit, notamment quand les signaux d'entrée sont de haute fréquence. Si les signaux d'entrée sont de haute fréquence, les transitions de conductivité se succèdent rapidement. Par conséquence, les diodes seront bruyantes pendant une portion du temps considérable.

Si le circuit intégré contenant le mélangeur à diodes est muni d'un substrat non-conducteur il n'y a pas de capacités parasites entre les diodes et le substrat. Par contre, si le substrat est semi-conducteur comme pour la plupart des circuits intégrés, des capacités parasites importantes existeront entre les diodes et le substratum. Plus la valeur des capacités parasites est faible, plus grande est la vitesse avec laquelle on peut changer la conductivité des diodes et, par conséquence, plus courtes sont les périodes pendant lesquelles les diodes sont bruyantes. Donc, un substrat non-conducteur contribue à une performance satisfaisante du circuit mélangeur en terme de bruit, notamment à haute fréquence.

En outre, il est préférable que les diodes D sont du type "Shottky". Les diodes de ce type peuvent changer de conductivité en relativement peu de temps. Par conséquence, si les diodes D dans le circuit mélangeur sont du type Shottky, les périodes bruyantes de ces diodes seront relativement courtes. Donc, l'utilisation des diodes Shottky dans le circuit mélangeur selon l'invention contribue également à une performance favorable en terme de bruit, notamment à haute fréquence.

REMARQUES DE CONCLUSION

Les figures et leur description ci-dessus illustrent l'invention plutôt qu'elles ne la limitent. Il est évident qu'il existe de nombreuses alternatives qui rentrent dans la portée des revendications ci-jointes. A cet égard quelques remarques de conclusion sont faites.

Les entités fonctionnelles ou fonctions peuvent être réparties de nombreuses manières différentes. A cet égard, il faut noter que les figures sont très schématiques, chaque figure représentant uniquement une seule réalisation de l'invention. Par exemple, en ce qui concerne Fig. 1, on peut bien envisager d'avoir un seul circuit intégré comportant le circuit mélangeur à diodes MIX, et l'oscillateur OSC. Le circuit d'entrée INP peut également être compris dans cet circuit intégré, soit en entier, soit en partie. La même chose s'applique par rapport au circuit de fréquence intermédiaire IFC.

Quoique la Fig. 1 illustre l'application d'un circuit mélangeur à diodes MIX selon l'invention dans un récepteur, ceci n'exclut pas des applications dans d'autres entités. Par exemple, un circuit mélangeur à diodes selon l'invention peut également être appliqué dans un processeur numérique pour mélanger deux signaux numériques.

Quoique la Fig. 4 illustre un circuit d'attaque DRIV réalisé à base de paires différentielles de transistors, ceci n'exclut pas d'autres réalisations. Par exemple, le circuit d'attaque peut être également réalisé à base d'amplificateurs opérationnels ou à base de transistors individuels.

Quoique la Fig. 4 illustre qu'on peut utiliser des transistors TD montés en diodes pour engendrer des tensions de décalage, ceci n'exclut pas l'utilisation d'autres éléments dans ce but. Par exemple, on peut également utiliser des résistances pour engendrer des tensions de décalage.

Finalement, aucun signe de référence entre parenthèses qui se trouve dans une revendication, ne doit être interprété d'une façon limitative.

**Revendications**

1. Un circuit mélangeur à diodes pour mélanger un premier et un deuxième signal d'entrée (LO,RF), **caractérisé en ce que** le circuit mélangeur comprend:

   un circuit d'attaque (DRIV) pour fournir un premier, deuxième, troisième et quatrième signal d'attaque (DS1,DS2,DS3,DS4) chaque signal d'attaque étant une combinaison du premier et du deuxième signal d'entrée (LO,RF), le premier et le deuxième signal d'entrée (LO,RF) ayant des signes suivants dans le premier, deuxième, troisième et quatrième signal d'attaque: +/+ (DS1 : +LO+RF), +/- (DS2 : +LO-RF), -/+ (DS3 : -LO+RF), -/- (DS4 : -LO-RF), respectivement; et
   un groupe de diodes (D1-D4) comprenant une première, deuxième, troisième et quatrième diode (D1,D2,D3,D4) étant couplé pour transférer le premier, deuxième, troisième et quatrième signal d'attaque (DS1,DS2,DS3,DS4), respectivement, vers une sortie (O1), la première et la quatrième diode (D1,D4) ayant la même polarité par rapport à la sortie (O1), et la deuxième et la troisième diode (D2,D3) ayant la même polarité par rapport à la sortie (O1) mais opposée à celle de la première et quatrième diode (D1,D4).

2. Un circuit mélangeur à diodes comme revendiqué dans la revendication 1, **caractérisé en ce que** le circuit mélangeur comprend un groupe de diodes additionnel (D5-D8) comprenant une cinquième, sixième, septième et huitième diode (D5,D6,D7,D8) couplées pour transférer le premier, deuxième, troisième et quatrième signal d'attaque (DS1,DS2,DS3,DS4), respectivement, vers une sortie additionnelle (O2), les cinquième, sixième, septième et huitième diodes (D5,D6,D7,D8) étant couplées à l'envers par rapport à la première, deuxième, troisième et quatrième diode (D1,D2,D3,D4), respectivement.

3. Un circuit mélangeur à diodes comme revendiqué dans la revendication 1, **caractérisé en ce que** le circuit d'attaque (DRIV) comprend des moyens (TD1 - TD4) pour fournir des tensions de décalage (Vbias1, Vbias2) entre la première et la troisième diode (D1, D3) et entre la deuxième et la quatrième diode (D2, D4), respectivement.

4. Un récepteur comprenant :

   un circuit d'entrée (INP) pour traiter un signal de réception ;
   un oscillateur (OSC) pour fournir un signal de battement ;
   un circuit mélangeur (MIX) comme revendiqué dans la revendication 1, couplé pour mélanger le signal de réception traité par le circuit d'entrée (INP) et le signal de battement fourni par l'oscillateur (OSC), afin d'obtenir un signal de fréquence intermédiaire (IF) ; et
   un circuit de fréquence intermédiaire (IFC) pour traiter le signal de fréquence intermédiaire (IF).

**Patentansprüche**

1. Diodenmischerschaltung zum Mischen eines ersten und eines zweiten Eingangssignals (LO, RF) **dadurch gekennzeichnet, dass** die Mischerschaltung enthält:

   eine Angriffsschaltung (DRIV) zur Lieferung eines ersten, zweiten, dritten und vierten Angriffssignals (DS1, DS2, DS3, DS4), wobei jedes Angriffssignal eine Kombination aus einem ersten und einem zweiten Eingangssignal (LO, RF) ist und das erste und das zweite Eingangssignal (LO, RF) im ersten, zweiten, dritten und vierten Angriffssignal jeweils folgende Vorzeichen haben: +/+ (DS1: +LO+RF), +/- (DS2: +LO-RF), -/+ (DS3: -LO+RF) und -/- (DS4: -LO-RF); und
   eine Diodengruppe (D1-D4) mit einer ersten, zweiten, dritten und vierten Diode (D1, D2, D3, D4), die für die jeweilige Übertragung des ersten, zweiten, dritten und vierten Angriffssignals (DS1, DS2, DS3, DS4) zu einem Ausgang (01) gekoppelt sind, wobei die erste und die vierte Diode (D1, D4) dieselbe Polarität in Bezug auf den Ausgang (01) haben und die zweite und die dritte Diode (D2, D3) dieselbe Polarität in Bezug auf den Ausgang (01) haben, doch entgegengesetzt zu der der ersten und der vierten Diode (D1, D4).

2.  Diodenmischerschaltung nach Anspruch 1, **dadurch gekennzeichnet, dass** die Mischerschaltung eine zusätzliche Diodengruppe (D5-D8) enthält, die enthält eine fünfte, sechste, siebte und achte Diode (D5, D6, D7, D8) enthält, die gekoppelt sind, um jeweils das erste, zweite, dritte und vierte Angriffssignal (DS1, DS2, DS3, DS4) an einen zusätzlichen Ausgang (02) zu leiten, wobei die fünfte, sechste, siebte und achte Diode (D5, D6, D7, D8) in Bezug auf jeweils die erste, zweite, dritte und vierte Diode (D1, D2, D3, D4) umgekehrt gekoppelt sind.

3.  Diodenmischerschaltung nach Anspruch 1, **dadurch gekennzeichnet, dass** die Angriffsschaltung (DRIV) Mittel (TD1 - TD4) enthält, um Versetzungsspannungen (Vbias1, Vbias2) zwischen respektive der ersten und der dritten Diode (D1, D3) und zwischen der zweiten und der vierten Diode (D2, D4) zu liefern.

4.  Empfänger bestehend aus:

    einer Eingangsschaltung (INP) zum Verarbeiten eines Empfangssignals;
    einem Oszillator (OSC) zum Liefern eines Überlagerungssignals;
    einer Mischerschaltung (MIX) wie in Patentanspruch 1 geltend gemacht, gekoppelt, um das Empfangssignal zu mischen, das von der Eingangsschaltung (INP) und von dem vom Oszillator (OSC) gelieferten Überlagerungssignal verarbeitet wurde, um ein Zwischenfrequenzsignal (IF) zu erhalten; und
    einer Zwischenfrequenzschaltung (IFC) zur Verarbeitung des Zwischenfrequenzsignals (IF).

## Claims

1.  A diode mixer circuit for mixing a first and a second input signal (LO, RF), **characterized in that** the diode mixer circuit comprises
    a driving circuit (DRIV) for producing a first, second, third and fourth drive signal (DS1, DS2, DS3, DS4), each drive signal being a combination of the first and the second input signal (LO, RF), the first and the second input signal (LO, RF) having the following signs in the first, second, third and fourth drive signal: +/+ (DS 1: +LO+RF), +/(DS2: +LO-RF), -/+ (DS3: -LO+RF) AND -/- (DS4:-LO-RF) respectively; and
    a group of diodes (D1-D4) comprising a first, second, third and fourth diode (D1, D2, D3, D4) which are coupled for transferring the first, second, third and fourth drive signal (DS1, DS2, DS3, DS4) respectively, to an output, the first and fourth diodes (D1, D4) having the same polarity relative to the output (01), and the second and third diodes (D2, D3) having the same polarity relative to the output (01), but opposite to that of the first and fourth diodes (D1, D4).

2.  A diode mixer circuit as claimed in claim 1, **characterized in that** the mixer circuit includes an additional group of diodes (D5-D8) containing a fifth, sixth, seventh and eighth diode (D5, D6, D7, D8) coupled for transferring the first, second, third and fourth drive signal (DS1, DS2, DS3, DS4) respectively, to an additional output (02), the fifth, sixth, seventh and eighth diodes (D5, D6, D7, D8) being coupled the other way around relative to the first, second, third and fourth diodes (D1, D2, D3, D4), respectively.

3.  A diode mixer circuit as claimed in claim 1, **characterized in that** the driving circuit (DRIV) comprises means (TD1-TD4) for producing bias voltages (Vbias1, Vbias2) between the first and third diodes (D1, D3) and between the second and fourth diodes (D2, D4), respectively.

4.  A receiver comprising:

    an input circuit (INP) for processing a received signal;
    an oscillator (OSC) for producing a beat signal;
    a mixer circuit (MIX) as claimed in claim 1, coupled for mixing the received signal processed by the input circuit (INP) and the beat signal produced by the oscillator (OSC) so as to obtain an intermediate frequency signal (IF); and
    an intermediate frequency circuit (IFC) for processing the intermediate frequency signal (IF).

MIX

FIG.1

EP 0 924 853 B1

FIG.2

FIG. 3

FIG.4